# EUROPEAN PATENT APPLICATION

(11) **EP 4 513 275 A1**
(43) Date of publication of application: **26.02.2025**
(21) Application number: 24196063.2
(22) Date of filing: 23.08.2024
(51) Int. Cl.: G04B 5/16, C23C 14/00, C23C 28/00, G04B 19/12, G04B 45/00, G04D 3/00, C22C 19/03

(54) **WATCH COMPONENT AND WATCH**

(30) Priority: 25.08.2023 JP 2023136972; 16.10.2023 JP 2023178414
(71) Applicant: Seiko Epson Corporation, Tokyo 160-8801 (JP)
(72) Inventor: FUJI, Tsubasa, Suwa-shi, 392-8502 (JP)
(74) Representative: Lewis Silkin LLP

(57) **Abstract**

A watch component includes a base material, a protective film formed on a surface of the base material by wet plating, and a decorative film formed on a surface of the protective film by dry plating, wherein the decorative film is a multilayer film in which a plurality of layers including a first layer in contact with the protective film are stacked, and a main material constituting the first layer is the same as a main material constituting the protective film.

## Description

The present application is based on, and claims priority from JP Application Serial Number 2023-136972, filed August 25, 2023 and JP Application Serial Number 2023-178414, filed October 16, 2023, the disclosures of which are hereby incorporated by reference herein in their entirety.

### BACKGROUND

### 1. Technical Field

The present disclosure relates to a watch component and a watch.

### 2. Related Art

JP-A-2023-4622 discloses, as a watch component such as a dial, a watch component having an appearance texture equivalent to that when a noble metal material is used and being capable of reducing a cost compared with the cost when a noble metal material is used due to a toning layer formed from a plurality of oxide films being stacked on a base material having a metallic luster.

Incidentally, when brass or the like is used as a base material of a dial, rust may occur on the base material. Therefore, it is considered that a protective film made of nickel or the like is formed on the surface of the base material by wet plating, and a plurality of oxide films having a function of a toning layer are stacked on the surface of the protective film by vacuum vapor deposition.

However, as a result of the research by the present inventor, it was found that, when a toning layer is formed by vacuum vapor deposition after the protective film is formed by wet plating, since the surface of the protective film is deactivated, an oxide film which is a first layer of the toning layer is merely placed on the protective film surface, the adhesion therebetween is low, and there is a concern of an occurrence of peeling when a tool or the like comes into contact with a dial surface during assembling of a watch, maintenance, or the like. Consequently, a watch component in which, when a protective film and a toning layer are stacked on the base material surface, the adhesion between the protective film and the toning layer can be improved and peeling does not readily occur and a watch including the watch component have been desired.

### SUMMARY

A watch component according to the present disclosure includes a base material, a protective film formed on a surface of the base material by wet plating, and a decorative film formed on a surface of the protective film by dry plating, wherein the decorative film is a multilayer film in which a plurality of layers including a first layer in contact with the protective film are stacked, and a main material constituting the first layer is the same as a main material constituting the protective film.

A watch according to the present disclosure includes the above-described watch component.

### BRIEF DESCRIPTION OF THE DRAWINGS

FIG. 1 is an elevation view illustrating a watch including a dial according to a first embodiment.
FIG. 2 is a sectional view illustrating the dial according to the first embodiment.
FIG. 3 is a diagram illustrating a film configuration of the dial according to the first embodiment.
Fig. 4 is a diagram illustrating peeling test results of a dial.
Fig. 5 is a diagram illustrating a film configuration of a dial according to a second embodiment.
FIG. 6 is a sectional view illustrating a dial according to a third embodiment.
Fig. 7 is a diagram illustrating a film configuration of the dial according to the third embodiment.

### DESCRIPTION OF EMBODIMENTS

A watch 1 according to an embodiment of the present disclosure will be described below with reference to the drawings.

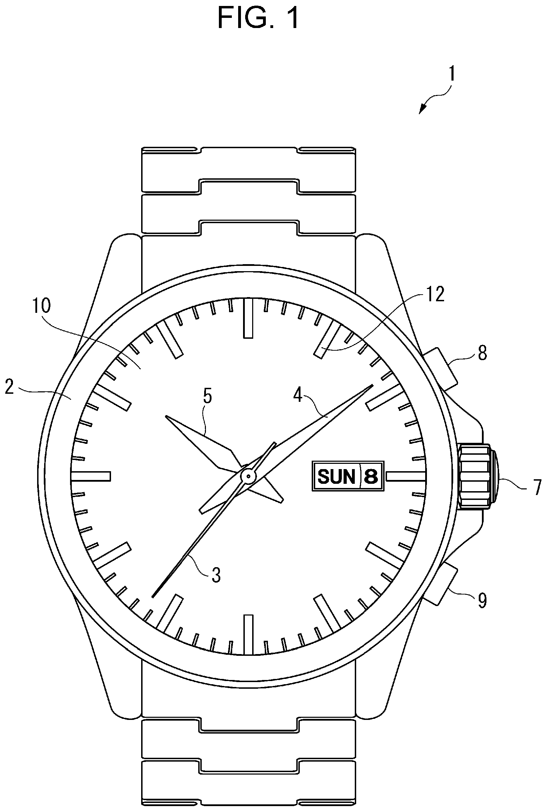

FIG. 1 is an elevation view illustrating a watch 1 including a dial 10 that is a watch component according to a first embodiment. The watch 1 is a wristwatch that is put on a wrist of a user and that includes a metal outer case 2, and a dial 10 is disposed on the inner circumferential side of the outer case 2. Of two openings of the outer case 2, a surface-side opening is closed with a cover glass, and a back-surface-side opening is closed with a back lid. Further, the watch 1 includes a movement, not illustrated in the drawing, housed in the outer case 2, a seconds hand 3, a minute hand 4, and an hour hand 5 which indicate time information, a crown 7, an A button 8, and a B button 9.

The dial 10 is provided with indices 12. The index 12 in the present embodiment is a bar index but may be an index by using a Roman numeral or an Arabic numeral, and the type of the index is not limited to the bar index.

In this regard, in the following description, the surface of each component means a cover-glass-side surface, and the back surface of each component means a back-lid-side surface. Dial

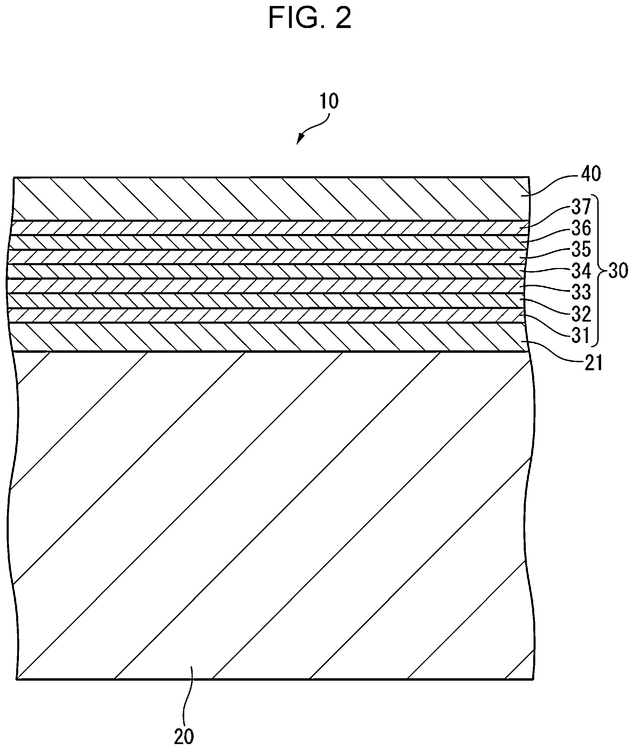

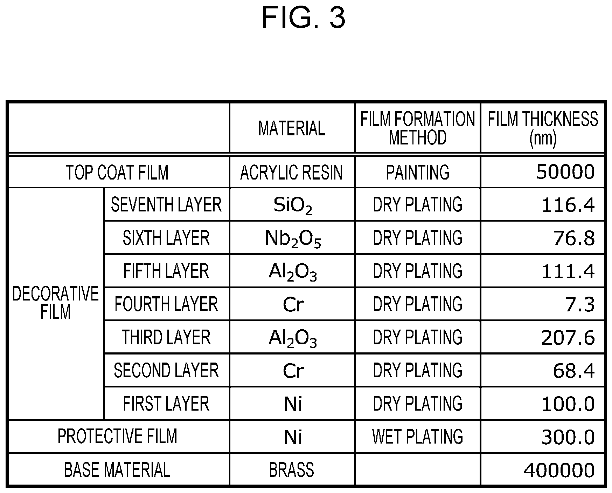

FIG. 2 is a schematic sectional view illustrating the dial 10 serving as a watch component. FIG. 3 is a diagram illustrating a material, a film formation method, and a film thickness of each film of the dial 10.

The dial 10 includes a base material 20, a protective film 21 formed on the surface of the base material 20, a decorative film 30 composed of a plurality of layers stacked on the surface of the protective film 21, and a top coat film 40 formed on the surface of the decorative film 30.

The base material 20 is a metal substrate serving as a base material of the dial 10. The base material 20 is, for example, a brass plate material having a thickness of about 400,000 nm = about 0.4 mm. In this regard, the material for forming the base material 20 is not limited to brass and may be a metal more base than a noble metal. Examples include nickel silver, Al, Ti, V, Cr, Fe, Co, Ni, Cu, Zn, Zr, Nb, Mo, In, Sn, Hf, Ta, W, Bi, and Mg and alloys containing at least one of these. In this regard, a small amount of noble metal is not limited to being inhibited from mixing.

The protective film 21 is a Ni plating layer formed on the surface of the base material 20 by wet plating such as electrolytic plating. That is, the protective film 21 is a film in which a main material is Ni and is a film in which, for example, the content of Ni serving as a main component is 99% or more, and the content of other components is about 1%. In this regard, the protective film 21 may have a content of Ni serving as a main component of less than 99% provided that the brass base material 20 can be protected so as to, for example, prevent rust from occurring on the base material 20. Further, the protective film 21 is formed by wet plating and, therefore, has excellent mass productivity.

The film thickness of the protective film 21 is, for example, about 300 nm. In this regard, the main material of the protective film 21 is not limited to Ni. It is sufficient that the material can realize a function such as a rust prevention function required of the protective film 21, and it is sufficient that the material can undergo wet plating of Au, Ag, Rh, or the like. In particular, Ni has an advantage that the cost can be reduced compared with Au, Ag, and Rh.

The decorative film 30 is disposed to adjust appearance, texture, and the like of the dial 10 and, in the present embodiment, composed of seven layers successively stacked from the protective film 21 side. That is, the decorative film 30 is configured to include a first layer 31, a second layer 32, a third layer 33, a fourth layer 34, a fifth layer 35, a sixth layer 36, and a seventh layer 37 successively stacked from the surface of the protective film 21.

In this regard, the film in the present embodiment means a portion formed into a film to realize a predetermined function. For example, the protective film 21 and the top coat film 40 are single-layer films formed of one type of material. On the other hand, the decorative film 30 is a multilayer film in which a plurality of layers formed of different materials are stacked to decorate the dial 10, specifically, to adjust the color and the luster of the dial 10.

The protective film 21 has a function of protecting the base material 20 and may have other functions, such as a function of contributing to decoration of the dial 10 with the decorative film 30.

It is sufficient that the decorative film 30, as a whole, has a function of decorating the dial 10, and a portion of the layers of the first layer 31 to the seventh layer 37 are not limited to directly contributing to decoration.

The first layer 31 to the seventh layer 37 constituting the decorative film 30 are formed by dry plating, such as vacuum vapor deposition, sputtering, and ion plating. A specific film formation method by the dry plating may be set in accordance with the material and the characteristics of each layer.

The first layer 31 is formed on the surface of the protective film 21 by dry plating such as vacuum vapor deposition. A main material constituting the first layer 31 is the same material as the material for constituting the protective film 21, that is, Ni. Since wet plating Ni of the protective film 21 and dry plating Ni of the first layer 31 are the same material and, therefore, a metal bond is generated, the adhesion can be improved compared with that when an oxide film is formed on the surface of the protective film 21. That is, although the first layer 31 is a layer constituting the decorative film 30, the first layer 31 is disposed mainly to enhance adhesion to the protective film 21. Therefore, the first layer 31 may be a layer which does not contribute to decoration or which contributes to decoration a little. The film thickness of the first layer 31 is, for example, about 100 nm. The first layer 31 is a layer in which, for example, the content of Ni serving as a main component is 99% or more, and the content of other components is about 1%. In this regard, the first layer 31 may have a content of Ni serving as a main component of less than 99% provided that the performance necessary for adhesion to the protective film 21 can be ensured.

The second layer 32 is formed on the surface of the first layer 31 by dry plating such as vacuum vapor deposition. A main material constituting the second layer 32 is Cr. Since Cr has high affinity for Ni, high adhesiveness, and high light reflectance of about 60% or more, the degree of design flexibility of the color, the luster, and the like of the dial 10 in accordance with the third layer 33 to the seventh layer 37 can be made high. That is, when the dial 10 is visually recognized from the surface, since the reflectance of the second layer 32 is high, influences of the base material 20, the protective film 21, and the first layer 31 on the color of the dial 10 can be reduced, and the color, the luster, and the like of the dial 10 can be flexibly designed in accordance with the configuration of the third layer 33 to the seventh layer 37. Therefore, the second layer 32 has a function of enhancing the adhesiveness to the first layer 31 and a function of contributing to the decoration. The film thickness of the second layer 32 is, for example, 68.4 nm. The second layer 32 is a layer in which, for example, the content of Cr serving as a main component is 99% or more, and the content of other components is about 1%. In this regard, the second layer 32 may have a content of Cr serving as a main component of less than 99% provided that the performance necessary for adhesion to the first layer 31 and light reflectance can be ensured.

The third layer 33 to the seventh layer 37 are formed of any one of a metal material, an oxide, and a fluoride, and the materials and the film thicknesses of these layers are set in accordance with the color of the dial 10. In the present embodiment, the third layer 33 to the seventh layer 37 are formed of a main material that is the material illustrated in Fig. 3 so as to have a film thickness illustrated in Fig. 3.

The third layer 33 is formed on the surface of the second layer 32 by dry plating such as vacuum vapor deposition. The third layer 33 is formed of Al₂O₃, and the film thickness thereof is, for example, 207.6 nm.

The fourth layer 34 is formed on the surface of the third layer 33 by dry plating such as vacuum vapor deposition. The fourth layer 34 is formed of Cr, and the film thickness thereof is, for example, 7.3 nm.

The fifth layer 35 is formed on the surface of the fourth layer 34 by dry plating such as vacuum vapor deposition. The fifth layer 35 is formed of Al₂O₃, and the film thickness thereof is, for example, 111.4 nm.

The sixth layer 36 is formed on the surface of the fifth layer 35 by dry plating such as vacuum vapor deposition. The sixth layer 36 is formed of Nb₂O₅, and the film thickness thereof is, for example, 76.8 nm.

The seventh layer 37 is formed on the surface of the sixth layer 36 by dry plating such as vacuum vapor deposition. The seventh layer 37 is formed of SiO₂, and the film thickness thereof is, for example, 116.4 nm.

The third layer 33 to the seventh layer 37 are layers that contribute to decoration and have adhesiveness so that a stacking state can be maintained without occurrence of peeling between the layers.

The top coat film 40 is formed by painting an acrylic resin on the surface of the decorative film 30, specifically the surface of the seventh layer 37, by using a spray gun or the like. The top coat film 40 is disposed to protect the decorative film 30 and, in addition, to provide a luster and adjust a color tone. The film thickness of the top coat film 40 is about 50,000 nm = about 0.05 nm.

According to the dial 10 having the above-described configuration, in particular, the decorative film 30 being composed of the first layer 31 to the seventh layer 37, the material and the film thickness of which are as illustrated in Fig. 3, set the color of the dial 10 to be red, specifically the color expressed by the brightness L* = 37, the chroma C* = 53, and the hue angle h = 13.

### Peeling test result

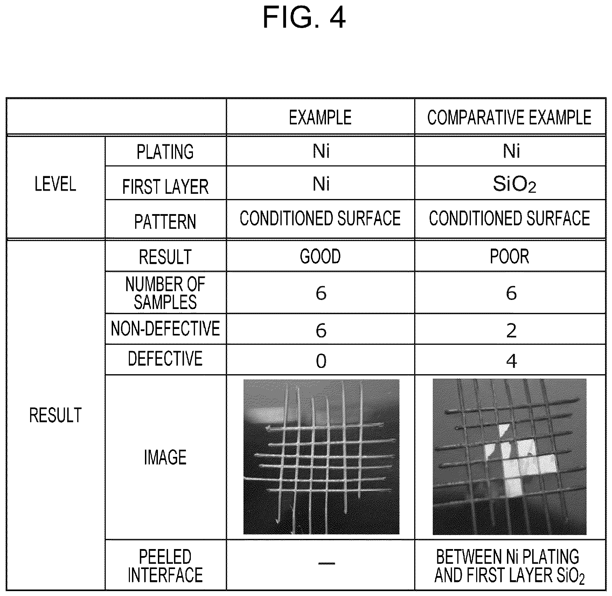

Fig. 4 illustrates the results of the peeling test in which the adhesiveness of the dial 10 of the first embodiment that is an example and a dial of a comparative example were tested.

The dial of the comparative example differs from the dial 10 of the first embodiment in that the first layer 31 of the decorative film 30 is set to be SiOz, and other configurations are the same. In this regard, a pattern "conditioned surface" in Fig. 4 means that the surface of the base material 20 is polished and flattened.

The peeling test is performed in the following procedure. Six samples for each of the example and the comparative example are prepared, linear cuts are made on the surface thereof in two directions intersecting each other by using a cutter so as to divide into about 1-mm-square rectangular regions. Subsequently, an adhesive tape is attached to the surface of each sample. Thereafter, the adhesive tape is peeled off, and whether the decorative film 30 is peeled off the base material 20 is tested.

As illustrated in Fig. 4, in the example, regarding all six samples, peeling did not occur in the rectangular regions divided by the cuts, and, therefore, it was ascertained that nondefective products in which the decorative film 30 had high adhesiveness were formed.

On the other hand, in the comparative example, regarding four samples of the six samples, peeling occurred in the rectangular regions divided by the cuts. When defective products in which peeling occurred were examined, it was ascertained that peeling occurred between the Ni plating protective film 21 and the SiO₂ first layer 31.

As described above, according to the dial 10 of the first embodiment and the watch 1 including the dial 10, the following effects can be exerted.

That is, although the protective film 21 formed on the surface of the base material 20 differs from the first layer 31 of the decorative film 30 formed on the surface of the protective film 21 in the film formation method, since the main materials are set to be the same material Ni, the adhesiveness can be enhanced due to a metal bond, and the decorative film 30 can be prevented from peeling off the protective film 21.

Since the protective film 21 is formed by wet plating of Ni, the film formation can be performed with high mass productivity at a low cost.

### Second embodiment

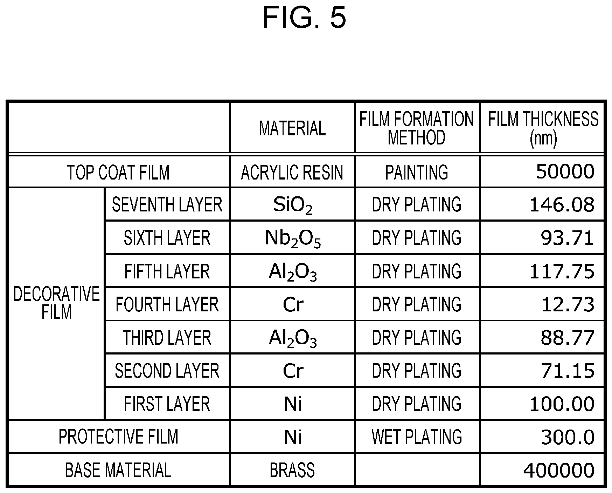

Next, a second embodiment will be described with reference to Fig. 5. In this regard, the dial 10 of the second embodiment differs from the dial 10 of the first embodiment in only the film thicknesses of the second layer 32 to the seventh layer 37 of the decorative film 30, and other configurations are the same as the first embodiment. Therefore, explanations are provided by using the same references.

Since the materials, the film formation methods, and the film thicknesses of the base material 20, the protective film 21, the first layer 31 of the decorative film 30, and the top coat film 40 of the dial 10 of the second embodiment are the same as that of the first embodiment, the explanations thereof are omitted.

The materials and the film formation methods of the second layer 32 to the seventh layer 37 of the decorative film 30 are the same as that of the first embodiment, and only the film thicknesses differ. That is, the film thickness of the second layer 32 formed of Cr is 71.15 nm. The film thickness of the third layer 33 formed of Al₂O₃ is 88.77 nm. The film thickness of the fourth layer 34 formed of Cr is 12.73 nm. The film thickness of the fifth layer 35 formed of Al₂O₃ is 117.75 nm. The film thickness of the sixth layer 36 formed of Nb₂O₅ is 93.71 nm. The film thickness of the seventh layer 37 formed of SiO₂ is 146.08 nm.

According to the dial 10 of the second embodiment having the above-described configuration, in particular, the decorative film 30 being composed of the first layer 31 to the seventh layer 37, the material and the film thickness of which are as illustrated in Fig. 5, set the color of the dial 10 to be violet, specifically, the color expressed by the brightness L* = 31, the chroma C* = 38, and the hue angle h = -45.

The dial 10 of the second embodiment differs from the dial 10 of the first embodiment in only the film thicknesses of the second layer 32 to the seventh layer 37, and, therefore, the same effect as that of the first embodiment can be exerted. That is, since the protective film 21 and the first layer 31 are formed of the same Ni, the adhesiveness can be enhanced due to a metal bond, and the decorative film 30 can be prevented from peeling.

### Third embodiment

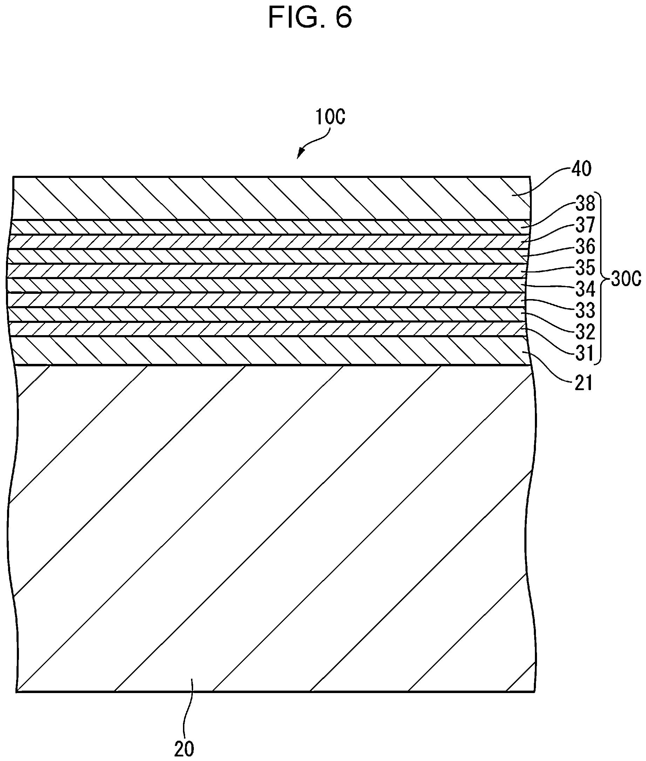

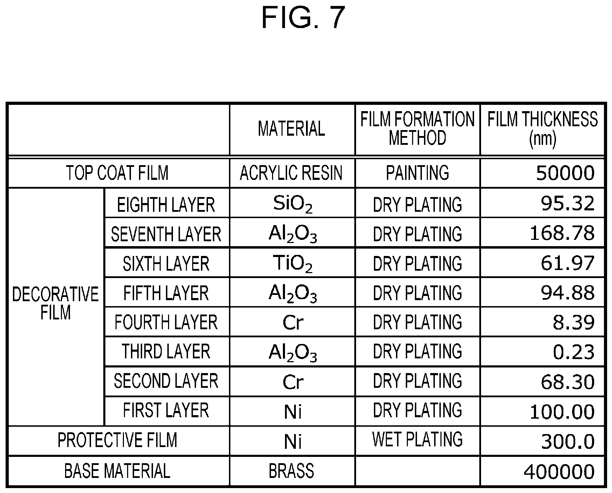

Next, a dial 10C of a third embodiment will be described with reference to Fig. 6 and Fig. 7.

The dial 10C is configured to include the base material 20, the protective film 21, a decorative film 30C, and the top coat film 40. Since the materials, the film formation methods, and the film thicknesses of the base material 20, the protective film 21, and the top coat film 40 are the same as that of the dial 10 of the first embodiment and the second embodiment, the same references are adopted and the explanations thereof are omitted.

In the decorative film 30C, eight layers of the first layer 31 to an eighth layer 38 are stacked.

The first layer 31 is formed of Ni made into a film by dry plating as in the first embodiment and the second embodiment, and the film thickness thereof is 100 nm.

The second layer 32 is formed of Cr made into a film by dry plating, and the film thickness thereof is 68.3 nm. The third layer 33 is formed of Al₂O₃ made into a film by dry plating, and the film thickness thereof is 0.23 nm. The fourth layer 34 is formed of Cr made into a film by dry plating, and the film thickness thereof is 8.39 nm. The fifth layer 35 is formed of Al₂O₃ made into a film by dry plating, and the film thickness thereof is 94.88 nm. The sixth layer 36 is formed of TiO₂ made into a film by dry plating, and the film thickness thereof is 61.97 nm. The seventh layer 37 is formed of Al₂O₃ made into a film by dry plating, and the film thickness thereof is 168.78 nm. The eighth layer 38 is formed of SiO₂ made into a film by dry plating, and the film thickness thereof is 95.32 nm.

According to the dial 10C of the third embodiment having the above-described configuration, in particular, the decorative film 30C being composed of the first layer 31 to the eighth layer 38, the material and the film thickness of which are as illustrated in Fig. 7, set the color of the dial 10C to be green, specifically, the color expressed by the brightness L* = 88, the chroma C* = 45, and the hue angle h = 102.

The dial 10C of the third embodiment differs from the dial 10 of the first embodiment in the materials and the film thicknesses of the second layer 32 to the eighth layer 38. However, since the protective film 21 and the first layer 31 are formed of the same Ni as in the first embodiment, the adhesiveness can be enhanced due to a metal bond, and the decorative film 30C can be prevented from peeling as in the first embodiment.

### Modified example

The main materials constituting the protective film 21 and the first layer 31 are not limited to Ni and may be, for example, Au, Ag, or Rh. That is, since the main materials constituting the protective film 21 and the first layer 31 are the same material, it is sufficient that the material can form a film on the base material 20 by wet plating, can form a film on the surface of the protective film 21 by dry plating, and has a function of protecting the base material 20, such as rust prevention.

The main material constituting the second layer 32 is not limited to Cr and may be Al, Au, Ag, or the like since it is sufficient that the material has high adhesiveness to the first layer 31 and a reflectance of more than or equal to a predetermined value. That is, it is sufficient that the second layer 32 can have a visible light reflectance of 50% or more and preferably 60% or more so as to decrease visible light which passes through the second layer 32 and to reduce the influence on the color, the luster, and the like of the watch component by the first layer 31, the protective film 21, and the base material 20 disposed on the back surface side of the second layer 32.

The number, the material, and the film thickness of each of the third layer 33 and subsequent layers are not limited to the configuration of each of the above-described embodiments and may be set in accordance with the design of the color and the luster of the watch component. For example, in the decorative films 30 and 30C, when a metal material layer is disposed as each of the third layer 33 and subsequent layers other than the first layer 31 and the second layer 32, the material thereof is not limited to Cr and may be Al, Ti, V, Fe, Co, Ni, Cu, Zn, Zr, Nb, Mo, In, Sn, Hf, Ta, W, Bi, or Mg. In this regard, when a layer of an oxide or a fluoride is disposed as each of the third layer 33 and subsequent layers, the material may be selected from, for example, Ta₂O₅, SiO₂, TiO₂, Al₂O₃, ZrOz, NbzOs, HfO₂, Na₅Al₃F₁₄, Na₃AlF₆, AlF₃, MgF₂, CaF₂, BaF₂, YF₃, LaF₃, CeF₃, and NdF₃ in accordance with the color.

The material of the base material 20 have been described as a metal but is not limited to this. For example, a base material formed of a material other than metal, such as a synthetic resin, may be used.

In each of the above-described embodiments, the material of the top coat film 40 disposed on the surfaces of the decorative films 30 and 30C is not limited to an acrylic resin. In this regard, the watch component is not limited to including the top coat film 40. Further, the top coat film 40 may be disposed only to protect the decorative films 30 and 30C.

The watch component is not limited to the dials 10 and 10C and may apply to externally visible various watch components in a watch. Examples of the applicable watch component in, for example, a skeleton model watch include an oscillating weight, a gear train, an escape wheel and pinion, a pallet fork, a train wheel bridge, and an oscillating weight bridge which are externally visible in a movement.

Further examples of the watch component include the outer case 2, the crown 7, the back lid, the band, and the like which are formed of metal materials.

### Outline of the present disclosure

A watch component according to the present disclosure includes a base material, a protective film formed on a surface of the base material by wet plating, and a decorative film formed on a surface of the protective film by dry plating, wherein the decorative film is a multilayer film in which a plurality of layers including a first layer in contact with the protective film are stacked, and a main material constituting the first layer is the same as a main material constituting the protective film.

According to the watch component of the present disclosure, since the main material of the protective film formed on the surface of the base material by wet plating and the main material of the first layer of the decorative film formed on the protective film by dry plating are configured to be the same material, the affinity between the protective film and the first layer can be enhanced, the adhesiveness therebetween can be improved, and the decorative film can be prevented from peeling.

In addition, since the protective film is formed by wet plating, excellent mass productivity is exhibited, and the cost can be reduced. Further, since the decorative film is a multilayer film in which a plurality of layers are stacked, and each layer is formed by dry plating, the film thickness of each layer can be accurately set, and the color of the watch component influenced by the film thickness can be accurately set to be a predetermined color.

In the watch component according to the present disclosure, the main material constituting the protective film and the first layer may be Ni.

According to the watch component of the present disclosure, since the protective film is formed by making Ni serving as a main material into a film by wet plating, the protective film having a rust prevention effect can be formed at a low cost. Further, the first layer of the decorative film is formed by making Ni into a film by dry plating, the adhesiveness can be improved due to Ni of the protective film and Ni of the first layer forming a metal bond.

In the watch component according to the present disclosure, the decorative film may include a second layer in contact with the first layer and a third layer and subsequent layers stacked on the surface side of the second layer, and a main material constituting the second layer may be a material having high adhesiveness to the first layer and a reflectance more than or equal to a predetermined value.

According to the watch component of the present disclosure, since the main material of the second layer of the decorative film is configured to be a material having high adhesiveness to the first layer, peeling between the first layer and the second layer of the decorative film can be prevented from occurring. In addition, since the main material constituting the second layer of the decorative film is configured to be a material having a reflectance of more than or equal to a predetermined value, when the watch component is viewed from the surface side, the base material, the protective film, and the first layer of the decorative film which are disposed on the back side of the second layer are prevented from exerting an influence on the color of the watch component. Consequently, the color of the watch component can be readily set by the materials and the film thicknesses of the third layer and subsequent layers of the decorative film.

In the watch component according to the present disclosure, the main material constituting the second layer may be Cr.

According to the watch component of the present disclosure, since the second layer of the decorative film is formed of Cr, the first layer of the decorative film being formed of a material such as Ni having high affinity for Cr enables the adhesiveness between the first layer and the second layer to be enhanced and peeling between the first layer and the second layer of the decorative film to be prevented from occurring.

In addition, since Cr has a high reflectance, when the watch component is viewed from the surface side, the base material, the protective film, and the first layer of the decorative film which are disposed on the back side of the second layer are prevented from exerting an influence on the color of the watch component. Consequently, the color of the watch component can be readily set by the materials and the film thicknesses of the third layer and subsequent layers of the decorative film.

In the watch component according to the present disclosure, the third layer and subsequent layers may include a layer formed of a metal material and a layer formed of an oxide or a fluoride.

According to the watch component of the present disclosure, since a layer formed of a metal material and a layer formed of an oxide or a fluoride are disposed in the third layer and subsequent layers of the decorative film, the color of the watch component can be readily set by the materials and the film thicknesses of the third layer and subsequent layers.

In the watch component according to the present disclosure, the layer formed of a metal material may be composed of a material containing at least one selected from a group consisting of Cr, Au, Ag, and Rh.

According to the watch component of the present disclosure, since the third layer and subsequent layers, in the decorative film, that exert an influence on the color of the watch component include a layer formed of a metal material containing at least one selected from a group consisting of Cr, Au, Ag, and Rh, the watch component can have a predetermined metallic luster.

In the watch component according to the present disclosure, the layer formed of an oxide or a fluoride may be composed of a material containing at least one selected from a group consisting of Ta₂O₅, SiOz, TiO₂, Al₂O₃, ZrOz, Nb₂O₅, HfOz, Na₅Al₃F₁₄, Na₃AlF₆, AlF₃, MgF₂, CaF₂, BaF₂, YF₃, LaF₃, CeF₃, and NdF₃.

According to the watch component of the present disclosure, the display color of the watch component can be appropriately set by adjusting the materials and the film thicknesses of the layer configuration of the decorative film.

In the watch component according to the present disclosure, a top coat film formed on a surface of the decorative film may be included.

According to the watch component of the present disclosure, the decorative film can be protected by the top coat film, and a luster and a color tone of the watch component can be set.

In the watch component according to the present disclosure, the watch component may be a dial or a component of a movement.

According to the watch component of the present disclosure, a dial or a component of a movement, such as an oscillating weight, can be set to a predetermined color.

A watch according to the present disclosure includes the above-described watch component.

According to the watch of the present disclosure, a watch including a watch component that displays a predetermined color can be provided.

## Claims

1. A watch component comprising:
a base material;
a protective film formed on a surface of the base material by wet plating; and
a decorative film formed on a surface of the protective film by dry plating, wherein
the decorative film is a multilayer film in which a plurality of layers including a first layer in contact with the protective film are stacked, and
a main material constituting the first layer is the same as a main material constituting the protective film.

2. The watch component according to claim 1, wherein
the main material constituting the protective film and the first layer is Ni.

3. The watch component according to claim 1, wherein
the decorative film includes a second layer in contact with the first layer and a third layer and subsequent layers stacked on the surface side of the second layer, and
a main material constituting the second layer is a material having high adhesiveness to the first layer and a reflectance more than or equal to a predetermined value.

4. The watch component according to claim 3, wherein
the main material constituting the second layer is Cr.

5. The watch component according to claim 3, wherein
the third layer and subsequent layers include a layer formed of a metal material and a layer formed of an oxide or a fluoride.

6. The watch component according to claim 5, wherein
the layer formed of a metal material is composed of a material containing at least one selected from a group consisting of Cr, Au, Ag, and Rh.

7. The watch component according to claim 5, wherein
the layer formed of an oxide or a fluoride is composed of a material containing at least one selected from a group consisting of TazOs, SiOz, TiO₂, Al₂O₃, ZrOz, Nb₂O₅, HfOz, Na₅Al₃F₁₄, Na₃AlF₆, AlF₃, MgF₂, CaF₂, BaF₂, YF₃, LaF₃, CeF₃, and NdF₃.

8. The watch component according to claim 1, wherein
a top coat film formed on a surface of the decorative film is included.

9. The watch component according to claim 1, wherein
the watch component is a dial or a component of a movement.

10. A watch comprising the watch component according to claim 1.
